# DEMANDE DE BREVET EUROPEEN

(11) **EP 3 989 278 A2**
(43) Date de publication de la demande: **27.04.2022**
(21) Numéro de dépôt: 21204564.5
(22) Date de dépôt: 25.10.2021
(51) Int. Cl.: H01L 25/07, H05K 7/14

(54) **ENSEMBLE DE MODULES DE PUISSANCE À SEMI-CONDUCTEURS**

(30) Priorité: 26.10.2020 FR 2010945
(71) Demandeur: Commissariat à l'Energie Atomique et aux Energies Alternatives, 75015 Paris (FR)
(72) Inventeur: MARCAULT, Emmanuel, 38054 Grenoble Cedex 9 (FR); SOULIE, Sarah, 38054 Grenoble Cedex 9 (FR)
(74) Mandataire: Nony

(57) **Abrégé**

Ensemble de modules de puissance (10), chaque module de puissance comportant :
- au moins un premier (60a) et un deuxième (60b) composant disposés l'un au-dessus de l'autre de part et d'autre du substrat, chaque composant présentant au moins deux contacts de puissance,
- un premier élément de connexion (21) relié électriquement à un premier contact de puissance du premier composant et à un premier contact de puissance du deuxième composant,
- un deuxième élément de connexion (22) relié électriquement à un deuxième contact de puissance du premier composant,
- un troisième élément de connexion (23) relié électriquement à un deuxième contact de puissance du deuxième composant,
les premiers éléments de connexion des modules étant disposés d'un même côté de l'ensemble,
les deuxièmes éléments de connexion des modules étant disposés d'un même côté de l'ensemble,
les troisièmes éléments de connexion des modules étant disposés d'un même côté de l'ensemble.

## Description

La présente invention concerne les modules de puissance à semi-conducteurs, tels que ceux utilisés pour commuter de forts courants.

### Technique antérieure

Certains modules de puissance comportent deux transistors associés selon un montage en demi-pont, avec des bornes à relier à un bus continu et une sortie correspondant à une phase, destinée à être reliée à un équipement tel qu'une machine tournante électrique par exemple. Une capacité de découplage est connectée entre les bornes du bus continu. Des bornes sont également prévues pour la connexion à un circuit de commande (« driver » en anglais) des transistors.

En fonction du nombre de phases de l'équipement à alimenter ou de la puissance à commuter, plusieurs modules de puissance peuvent être utilisés, étant montés en parallèle le cas échéant.

Le développement des transistors à base de Nitrure de Galium a permis d'augmenter les fréquences de fonctionnement, ce qui rend critique l'effet des inductances parasites liées aux connexions au sein du module.

Aujourd'hui, la plupart des modules de puissance possède des connectiques de puissance placées côte-à-côte dans un même plan. La maille de commutation qui en découle est latérale, ce qui tend à augmenter les inductances parasites dans le circuit.

Il a été proposé dans la publication Perturbations électromagnétiques conduites d'un bras d'onduleur à base de transistors en Nitrure de Galium : Structure « 3D » pour composants horizontaux » Clement Fita et al., Symposium de Génie Electrique, Jun 2016, Grenoble, France*,* de réduire les inductances parasites en superposant verticalement selon un agencement en miroir les transistors du demi-pont de part et d'autre d'un substrat constitué par un circuit imprimé multicouche. Des trous sont réalisés dans le circuit imprimé pour placer les capacités de découplage au plus proche des transistors. La liaison de puissance entre les transistors est assurée par des pistes internes au substrat, et il en résulte en une structure relativement complexe, dans laquelle le substrat ne peut avoir un simple rôle de support mécanique et de dissipation thermique.

Les auteurs signalent que l'inconvénient d'une telle structure lorsque les transistors sont prévus pour être refroidis par le dessous, i.e. par le circuit imprimé, est la difficulté de dissiper la chaleur dégagée par les transistors, car les pertes thermiques sont prévues pour être évacuées par le circuit imprimé et chaque transistor gêne ainsi la dissipation des pertes thermiques du transistor opposé, étant donné leur disposition en miroir.

La demande WO 2018/024973 A1 décrit un procédé de fabrication d'un module de puissance tridimensionnel, comportant l'assemblage de deux substrats logeant chacun un composant de puissance.

La demande US 9 041 183 B2 décrit un module de puissance dans lequel les composants de puissance sont disposés de manière centrale entre deux substrats. Une telle structure n'est pas entièrement satisfaisante sur le plan de la dissipation des pertes thermiques, la dissipation s'effectuant à travers les substrats.

### Exposé de l'invention

Les équipements alimentés par les modules de puissance ont le plus souvent plusieurs phases ou sont commandés par des modules montés en parallèle, et il existe un besoin pour bénéficier d'un ensemble de modules multi-phase ou branchés en parallèle, qui soit à la fois compact et optimisé sur le plan de la dissipation thermique, tout en minimisant les inductances parasites.

### Résumé de l'invention

L'invention vise à répondre à ce besoin, et elle y parvient, selon un premier de ses aspects, en proposant un ensemble de modules de puissance, comportant au moins deux modules de puissance superposés, chaque module de puissance comportant :
- Un substrat isolant électrique, ayant des faces principales opposées,
- au moins un premier et un deuxième composant à semi-conducteur, disposés l'un au-dessus de l'autre de part et d'autre du substrat et reposant sur ses faces principales, chaque composant présentant au moins deux contacts de puissance,
- un premier élément de connexion relié électriquement à un premier contact de puissance du premier composant et à un premier contact de puissance du deuxième composant,
- un deuxième élément de connexion relié électriquement à un deuxième contact de puissance du premier composant,
- un troisième élément de connexion relié électriquement à un deuxième contact de puissance du deuxième composant,

les premiers éléments de connexion des modules étant disposés d'un même côté de l'ensemble,
les deuxièmes éléments de connexion des modules étant disposés d'un même côté de l'ensemble,
les troisièmes éléments de connexion des modules étant disposés d'un même côté de l'ensemble.

Le substrat forme au sein de chaque module un support central qui participe au maintien mécanique des composants de puissance du module, ainsi que des éléments de connexion.

Un tel ensemble de modules présente un agencement compact qui peut être refroidi efficacement.

L'ensemble présente également une configuration modulaire qui permet facilement d'augmenter ou de diminuer le nombre de modules superposés en fonction du nombre de phases de l'équipement utilisé ou du besoin de courant.

Le premier élément de connexion permet, en reliant le composant situé sur la face supérieure du substrat à celui situé sur la face inférieure du substrat, d'avoir une maille courte et une faible impédance parasite pour le module concerné. Chaque module peut ainsi présenter une inductance parasite de maille inférieure à 5 nH, par exemple de l'ordre de 2 nH, alors que celles dans un demi-pont usuel de l'art antérieur sont typiquement de l'ordre de 10 nH.

Chaque composant peut comporter au moins un contact de commande, par exemple un contact de Grille pour un transistor, chaque module comportant au moins deux bornes de sortie, notamment des bornes de sortie définies par des connecteurs portés par le module, pour relier électriquement les contacts de commande des composants de puissance à un circuit de commande, toutes les bornes de sortie, notamment tous les connecteurs, étant situés d'un même côté du module, et tous les connecteurs étant de préférence situés d'un même côté de l'ensemble de modules.

L'invention permet de limiter le déséquilibre entre les commandes des différents modules en raison de longueurs de conducteurs différentes, et ainsi de limiter le bruit. Le fait que les connexions au circuit de commande puissent se faire sur un même côté pour tous les modules de l'ensemble facilite la mise en parallèle des modules ou le multi-phase.

Le substrat peut contribuer à la dissipation thermique, en étant avantageusement réalisé dans un matériau bon conducteur thermique, tel qu'une céramique.

L'invention se prête à un fonctionnement à haute température, et peut s'appliquer à la commande moteur, au spatial, à l'aéronautique, ou au forage, entre autres applications. Le courant maximum commuté par l'ensemble de modules est par exemple d'intensité supérieure ou égale à 100A, en particulier lorsque les modules de l'ensemble sont reliés électriquement en parallèle. Les composants de puissance (encore parfois appelés « puces ») sont de préférence des transistors à base de GaN. Ces composants de puissance peuvent être encapsulés ou non, et présentent généralement au moins deux contacts de puissance (par exemple Source et Drain) et un contact de commande (par exemple Grille). Ils peuvent également présenter sur une face un patin thermique, destiné à être connecté thermiquement à un dissipateur thermique. De préférence, ce patin thermique est tourné du côté opposé au substrat. Des exemples de transistors à base de GaN sont proposés sous la marque GaN_{PX} par la société GaN Systems.

Les deuxièmes et troisièmes éléments de connexion peuvent définir des terminaisons destinées à être raccordées aux bornes d'un bus continu tandis que les premiers éléments de connexion définissent des bornes de phases, qui peuvent être le cas échéant reliées entre elles lors d'un montage en parallèle des modules de puissance.

De préférence, pour chaque module de puissance, le premier élément de connexion relie électriquement entre eux le premier contact de puissance du premier composant (par exemple la Source) et le premier contact de puissance du deuxième composant (par exemple le Drain), à l'extérieur du substrat. Cela peut contribuer à simplifier le substrat, qui n'a pas à intégrer de pistes électriques de puissance, et permet d'utiliser pour réaliser le substrat un matériau bon conducteur thermique tel qu'une céramique.

De préférence, chaque substrat présente une ouverture et chaque module de puissance comporte une capacité de découplage s'étendant au moins partiellement à travers cette ouverture, étant reliée électriquement à un contact de puissance de l'un des composants du module et à un contact de puissance de l'autre composant du module. Cela permet de diminuer encore les inductances parasites. La valeur de la capacité est par exemple de 3 à 5 nF par ampère commuté. De préférence, la capacité de découplage est située en regard des deuxième et troisième éléments de connexion et à leur contact, étant par exemple soudée à celle-ci, de préférence à proximité des composants de puissance.

Le substrat peut être monolithique, étant par exemple une céramique, comme mentionné plus haut, notamment une céramique à base de nitrure d'aluminium AlN ou d'alumine Al₂O₃.

De préférence, le substrat est réalisé avec des faces principales non entièrement planes, présentant au moins un relief en creux ou en saillie de positionnement du composant de puissance présent sur la face correspondante, d'un capot et/ou de l'un desdits éléments de connexion.

De préférence, le substrat présente, au moins pour les reliefs assurant le positionnement des composants de puissance, une forme symétrique par rapport à un plan médian de symétrie le coupant à mi-épaisseur.

Chaque composant peut comporter au moins un contact de commande (par exemple un contact de Grille), chaque module comportant au moins deux bornes de sortie, notamment des bornes de sortie définies par des connecteurs portés par le module, pour relier électriquement les contacts de commande des composants de puissance à un circuit de commande. Toutes les bornes de sortie, notamment tous les connecteurs, sont avantageusement situés d'un même côté du module, et tous les connecteurs sont de préférence situés d'un même côté de l'ensemble de modules. Cela permet de limiter les dissymétries dans la commande des composants en homogénéisant les longueurs des conducteurs de commande, de diminuer le bruit ainsi que les inductances parasites dans la commande, et peut faciliter le montage d'une carte de commande à proximité de l'ensemble de modules.

Le premier élément de connexion peut être formé par découpe et pliage d'une feuille d'un métal, de préférence du cuivre.

Par exemple, le premier élément de connexion comporte des première et deuxième branches décalées latéralement, s'étendant depuis une partie de jonction reliant les branches entre elles, chaque branche étant reliée à la partie de jonction par un premier coude sensiblement à angle droit, les deux premiers coudes étant dirigés dans des directions opposées, et chaque branche comportant un deuxième coude sensiblement à angle droit, de telle sorte que les portions terminales des première et deuxième branches soient sensiblement parallèles, ces portions terminales étant reliées électriquement chacune à un contact électrique d'un composant respectif.

De préférence, le premier élément de connexion comporte deux branches superposées s'étendant au contact l'une de l'autre sur une partie de leur longueur, puis à distance l'une de l'autre sur le reste de leur longueur.

De préférence, les éléments de connexion présentent des parties qui s'étendent hors du substrat et définissent des bornes électriques.

Chaque module peut comporter des capots opposés, en contact thermique avec les faces des composants opposées au substrat. Le substrat peut présenter des reliefs qui coopèrent avec des reliefs complémentaires des capots pour assurer le positionnement des capots sur le substrat dans une configuration prédéfinie.

De préférence, les deux composants de chaque module sont des transistors reliés ensemble (par exemple la Source de l'un est reliée au Drain de l'autre) pour former un demi-pont, mais d'autres agencements sont possibles. Les deux composants de chaque module sont de préférence identiques, mais en variante ils peuvent être différents, par exemple une diode et un transistor, avec par exemple la diode sur une face et le transistor sur l'autre.

De préférence, les deux composants sont des transistors à base de semi-conducteur à grand gap tel que le nitrure de gallium (GaN).

Dans un exemple de mise en œuvre, l'ensemble comporte au moins un refroidisseur entre deux modules adjacents, notamment un refroidisseur à ailettes. Les ailettes peuvent être réalisées de manière monolithique avec un capot précité, voire avec deux capots destinés à être rapportés sur des modules adjacents. Par exemple, les ailettes sont réalisées en métal ou en céramique avec un ou deux capots. L'ensemble peut ne pas comporter de boîtier ou d'encapsulation additionnelle s'étendant autour des substrats, lesquels restent alors apparents au sein de l'ensemble de module, sur leur pourtour. Chaque module peut comporter des capots opposés, en contact thermique avec des faces respectives des composants, opposées au substrat.

L'ensemble peut comporter au moins trois modules superposés, notamment présenter seulement trois modules superposés, mais l'invention n'est pas limitée à un nombre de modules superposés donné, et l'on peut prévoir par exemple au moins un module redondant.

L'invention a encore pour objet, selon un autre de ses aspects, indépendamment ou en combinaison avec ce qui précède, un module de puissance considéré isolément, ce module de puissance comportant :
- Un substrat isolant électrique, ayant des faces principales opposées,
- au moins un premier et un deuxième composant à semi-conducteur disposés l'un au-dessus de l'autre de part et d'autre du substrat et au contact de ses faces principales, chaque composant présentant au moins deux contacts de puissance,
- un premier élément de connexion reliant électriquement entre eux un premier contact de puissance du premier composant et un premier contact de puissance du deuxième composant, à l'extérieur du substrat,
- de préférence un deuxième élément de connexion relié électriquement à un deuxième contact de puissance du premier composant,
- de préférence un troisième élément de connexion relié électriquement à un deuxième contact de puissance du deuxième composant.

Un tel module peut présenter tout ou partie des caractéristiques des modules de l'ensemble défini plus haut.

L'invention a encore pour objet, selon un autre de ses aspects, indépendamment ou en combinaison avec ce qui précède, un module de puissance considéré isolément, ce module de puissance comportant :
- Un substrat isolant électrique, ayant des faces principales opposées,
- au moins un premier et un deuxième composant à semi-conducteur disposés l'un au-dessus de l'autre de part et d'autre du substrat et au contact de ses faces principales, chaque composant présentant au moins deux contacts de puissance,
- un premier élément de connexion reliant électriquement entre eux un premier contact de puissance du premier composant et un premier contact de puissance du deuxième composant,
- au moins deux connecteurs de commande des composants de puissance du module, situés sur un même côté du substrat, avec de préférence une direction d'enfichage sensiblement parallèle à un plan médian du substrat coupant celui-ci à mi-épaisseur,
- de préférence un deuxième élément de connexion relié électriquement à un deuxième contact de puissance du premier composant,
- de préférence un troisième élément de connexion relié électriquement à un deuxième contact de puissance du deuxième composant,

Un tel module peut présenter tout ou partie des caractéristiques des modules de l'ensemble défini plus haut.

L'invention a encore pour objet, indépendamment ou en combinaison avec ce qui précède, un substrat pour la réalisation d'un module d'un ensemble selon le premier aspect de l'invention tel que défini ci-dessus ou d'un module de puissance selon l'un des seconds ou troisième aspects de l'invention.

Ce substrat, qui peut avantageusement être réalisé en céramique, présente deux faces principales opposées définissant chacune un logement pour recevoir un composant de puissance respectif tel qu'un transistor de puissance, un logement pour un élément de connexion relié à un contact de puissance du composant de puissance, un logement pour un autre élément de connexion relié à un autre contact de puissance du composant, et au moins un canal relié à un contact de commande du composant de puissance, les canaux pour les conducteurs de commande débouchant sur un même côté du substrat, pour les deux faces du substrat.

Le substrat peut présenter une forme générale rectangulaire, les logements recevant les éléments de connexion reliés aux contacts de puissance débouchant de préférence sur les petits côtés du substrat et les canaux recevant les conducteurs reliés aux contacts de commande débouchant de préférence sur un même grand côté du substrat.

De préférence, les logements recevant les composants de puissance sont symétriques l'un de l'autre par rapport à un plan de symétrie coupant le substrat à mi-épaisseur.

De préférence également, les logements recevant les éléments de connexion aux contacts de puissance d'un composant de puissance situé sur une face sont symétriques de ceux recevant les éléments de connexion reliés aux contacts de puissance du composant situé sur l'autre face, par rapport à un plan de symétrie coupant le substrat à mi-épaisseur.

Par contre, les canaux situés sur une face et recevant les conducteurs reliés au connecteur de commande d'un composant présent sur cette face sont de préférence décalés latéralement par rapport aux canaux présents sur l'autre face et servant à la commande du composant de puissance présent sur cette autre face, de manière à faciliter le montage des connecteurs.

Le substrat peut comporter des reliefs de positionnement d'un capot sur chacune de ses faces, ce capot faisant office de dissipateur thermique en venant en contact thermique avec le composant de puissance qui lui fait face. Le capot peut, le cas échéant, être réalisé avec des ailettes de dissipation thermique.

Le substrat peut être réalisé par une technique de fabrication additive, notamment en céramique.

L'invention a encore pour objet, selon un autre de ses aspects, un double capot comportant un premier capot destiné à venir s'appliquer sur un premier substrat d'un premier module de puissance et un deuxième capot destiné à s'appliquer sur un deuxième substrat d'un deuxième module de puissance, les premier et deuxième capots étant solidaires, par exemple en étant fixés face contre face ou en étant reliées par des ailettes, lesquelles peuvent être réalisées de façon monolithique, le cas échéant, avec l'un au moins des capots. Chaque capot peut présenter des reliefs de positionnement destinés à coopérer avec des reliefs correspondants sur le substrats contre lequel il est destiné à s'appliquer, pour se positionner d'une manière prédéfinie sur celui-ci. Les capots peuvent présenter des faces métalliques ou métallisées destinés à venir thermiquement au contact des composants de puissance, via un frittage par exemple.

L'invention a encore pour objet un ensemble formé au moins de deux modules de puissance tels que définis ci-dessus, dont les substrats sont reliés par un tel double capot.

### Brève description des dessins

L'invention pourra être mieux comprise à la lecture de la description détaillée qui va suivre, d'exemples de réalisation non limitatifs de celle-ci, et à l'examen du dessin annexé, sur lequel :
[Fig 1] la figure 1 est une vue schématique en perspective d'un exemple d'ensemble de modules selon l'invention,
[Fig 2] la figure 2 représente l'ensemble de la figure 1 selon un autre angle de vue,
[Fig 3] la figure 3 représente l'ensemble de la figure 1 avec une coupe dans son épaisseur,
[Fig 4] la figure 4 est une vue analogue à la figure 3 dans un autre plan de coupe,
[Fig 5] la figure 5 est un schéma électrique illustrant la connexion d'un module au bus continu et à un circuit de commande, ainsi que les connexions internes au module,
[Fig 6] la figure 6 représente de manière schématique et partielle, en perspective, un module,
[Fig 7] la figure 7 représente isolément, en perspective, le substrat d'un module,
[Fig 8] la figure 8 est une vue du substrat de la figure 7 sous un autre angle de vue,
[Fig 9] la figure 9 est une coupe partielle d'un module illustrant de manière schématique le montage de la capacité de découplage,
[Fig 10] la figure 10 est une vue analogue à la figure 1 d'une variante d'ensemble de modules,
[Fig 11] la figure 11 représente l'ensemble de la figure 10 sous un autre angle de vue,
[Fig 12] la figure 12 est une coupe schématique de l'ensemble de la figure 10 selon son épaisseur,
[Fig 13] la figure 13 représente une variante d'élément de connexion, et
[Fig 14] la figure 14 représente isolément un transistor de puissance.

### Description détaillée

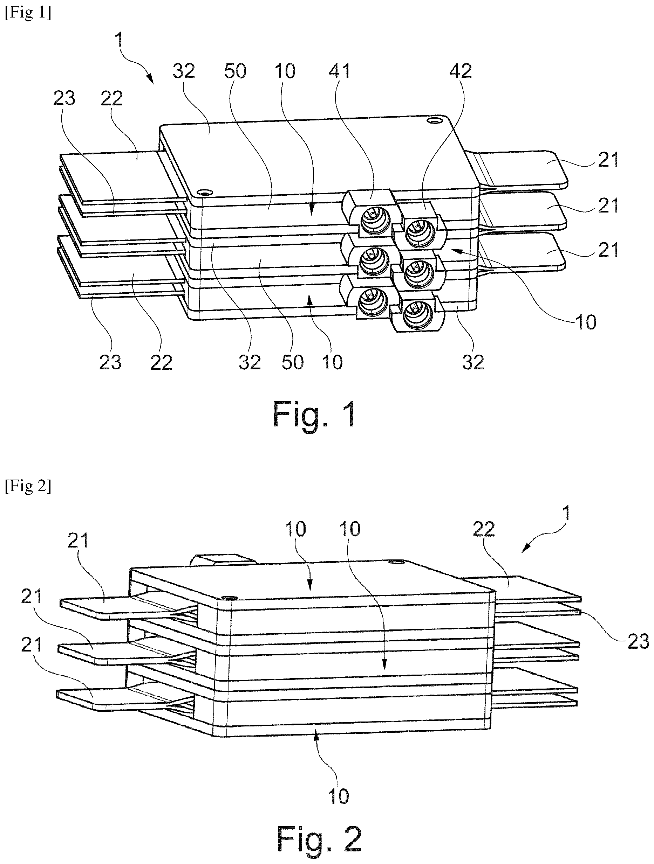

On a représenté aux figures 1 à 4 un exemple d'ensemble 1 de modules de puissance 10 conforme à l'invention.

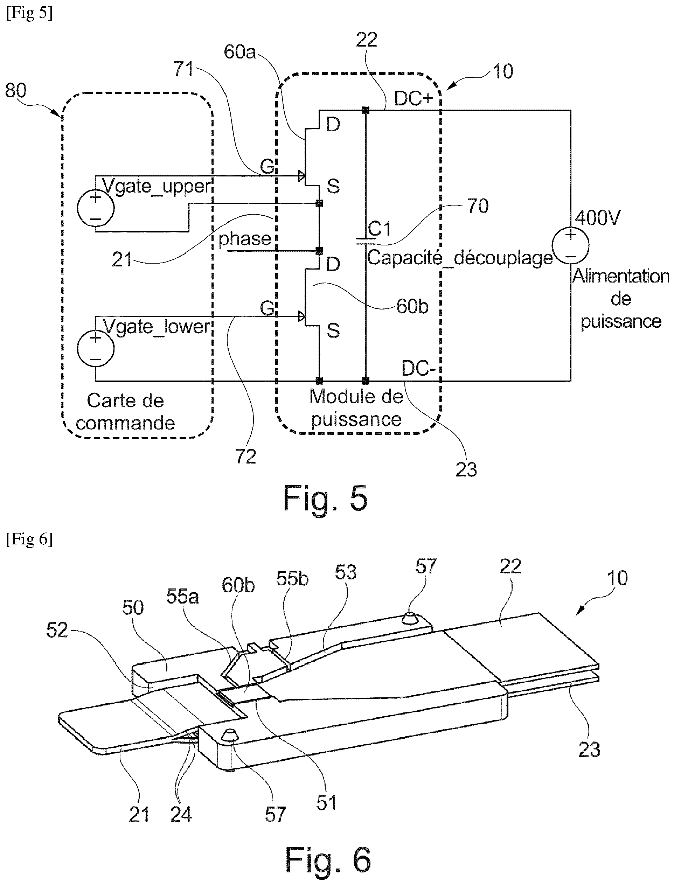

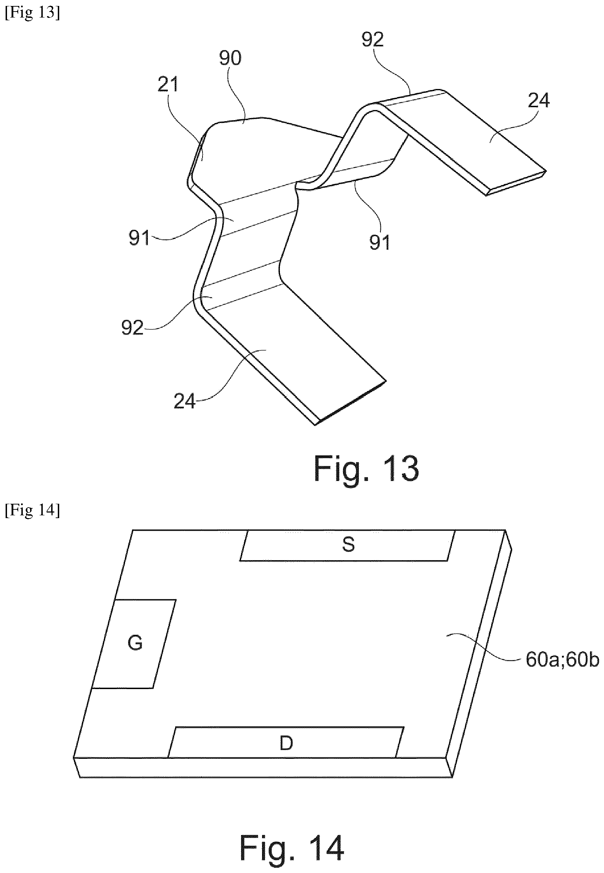

Dans l'exemple considéré, cet ensemble comporte trois modules 10 comportant chacun, comme illustré à la figure 5, deux transistors de puissance 60a, 60b reliés électriquement selon une configuration de demi-pont en H, et une capacité de découplage 70. On a représenté isolément à la figure 14 un transistor de puissance 60a ou 60b. On voit sur cette figure que le composant peut présenter une forme générale de parallélépipède rectangle aplati, les contacts S et D pouvant être à l'opposé l'un de l'autre le long des grands côtés du rectangle (en vue de dessus), et le contact G sur l'un des petits côtés.

L'ensemble est par exemple destiné à la commutation de forts courants à des fréquences élevées, et les modules 10 sont par exemple reliés électriquement en parallèle. Ainsi, l'ensemble 1 peut former un objet compact contenant plusieurs demi-ponts en parallèle, le nombre de demi-ponts ainsi associés au sein de l'ensemble 1 étant par exemple choisi en fonction de la puissance totale à commuter. En variante, les modules ne sont pas reliés électriquement en parallèle au niveau des phases de sortie, pour un branchement multi-phasé à l'équipement associé, par exemple.

Chaque module 10 est destiné à être connecté à un bus continu DC+, DC-, le transistor 60a en haut du pont ayant dans cet exemple son drain D relié à la borne DC+ du bus et celui 60b en bas du pont ayant sa source S reliée à la borne DC- du bus. La source S du transistor 60a du haut du pont est reliée au drain du transistor 60b du bas du pont et à la sortie de phase du demi-pont.

Les grilles G des transistors 60a, 60b sont destinées à être reliées par des connexions 71 et 72 à un circuit de commande 80.

La capacité de découplage 70 est connectée entre les bornes DC- et DC+ du bus.

En revenant à la figure 1, on voit que chaque module 10 présente en vue de dessus une forme générale rectangulaire, et que les bornes formées par les éléments de connexion 22, 23 à relier au bus continu sont situées d'un même petit côté de l'ensemble 1, tandis que les terminaisons des éléments de connexion 21 reliées aux phases sont situées du petit côté opposé.

Les connecteurs 41, 42 reliés aux grilles G des transistors 60a, 60b de chaque module 10 sont tous disposés d'un même côté de l'ensemble 1, en l'espèce sur un grand côté.

Chaque module 10 présente dans l'exemple illustré un substrat 50 et deux capots 32 disposés de part et d'autre du substrat 50.

Si l'on se reporte aux figures 6 à 8, on voit que chaque substrat 50 présente sur chacune de ses faces principales un logement 51 pour accueillir un transistor 60a ou 60b correspondant, et deux logements adjacents 52 et 53 débouchant respectivement sur les petits côtés du substrat 50.

Chaque logement 52 est destiné à accueillir l'une des branches 24 de l'élément de connexion 21 tandis que les logements 53 accueillent les éléments de connexion 22 et 23, respectivement.

Dans l'exemple considéré, les branches 24 du premier élément de connexion 21 sont formées par des lamelles de cuivre respectives, lesquelles se rejoignent et sont assemblées par leurs faces en regard pour former la borne de phase.

Le substrat 50 présente une paroi qui définit le fond des logements 53 et permet d'assurer l'isolation électrique entre les éléments de connexion 22 et 23.

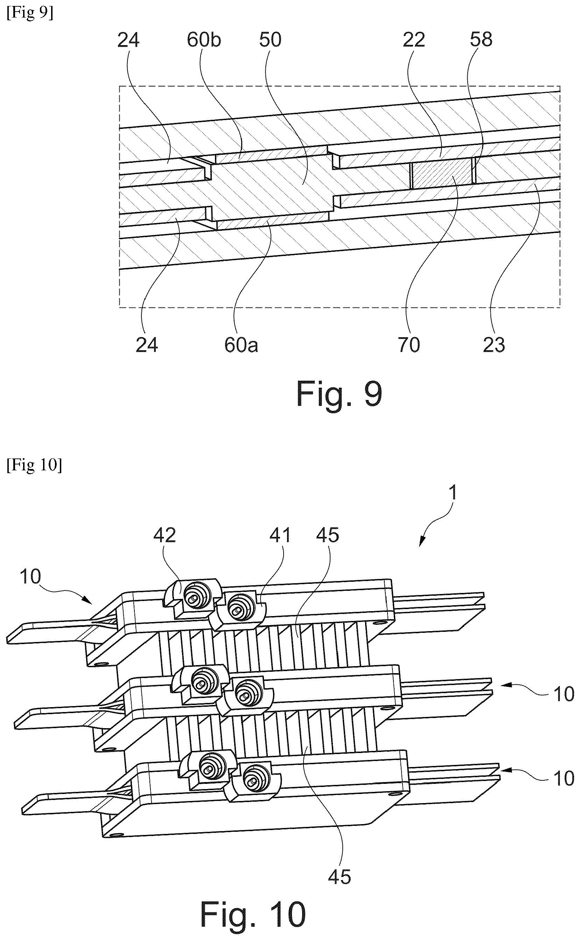

Cette paroi est traversée par une ouverture 58 qui accueille la capacité de découplage 70, comme illustré à la figure 9.

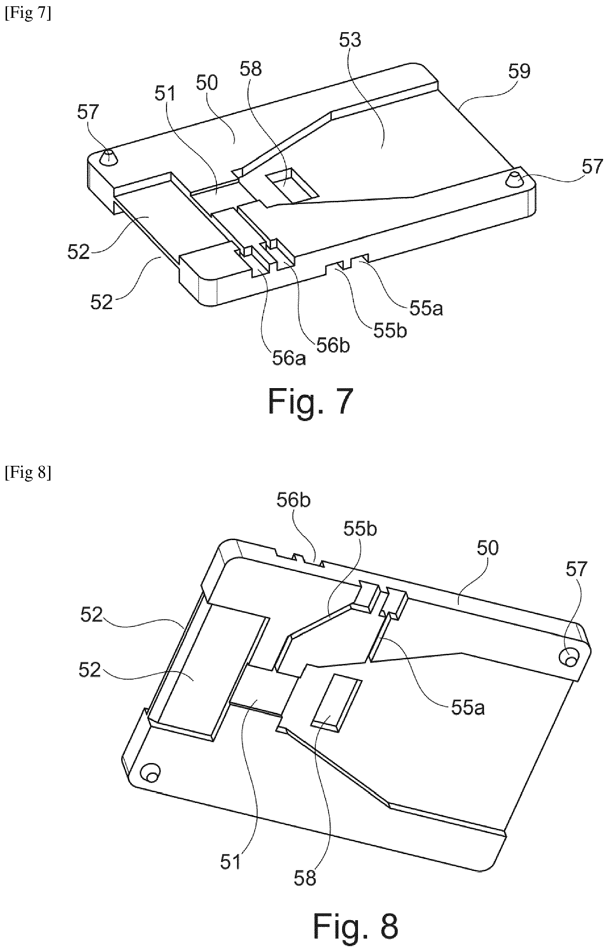

Des canaux 56b et 56a sont, comme illustré sur la figure 7, formés sur une face du substrat 50 pour accueillir les conducteurs électriques reliés respectivement à la grille du transistor 60a porté par cette face supérieure et à une prise de potentiel de référence (par exemple le potentiel de la source S pour le transistor 60a du haut du pont sur la figure 5). De même, le substrat 50 présente sur sa face opposée, comme illustré sur la figure 8, des canaux 55b et 55a pour accueillir respectivement les conducteurs reliés à la grille du transistor 60b correspondant et à une prise de potentiel de référence (par exemple le potentiel de la source S du transistor 60b du bas du pont sur la figure 5).

Les logements 51, 52 et 53 sont symétriques dans l'exemple considéré par rapport à un plan médian de symétrie, coupant le substrat 50 à mi-épaisseur. Les logements 55a, 55b, 56a et 56b sont décalés latéralement pour laisser entre eux l'espace suffisant pour accueillir les connecteurs 41 et 42. Le connecteur 41 est par exemple relié aux conducteurs s'étendant dans les canaux 55a et 55b, tandis que le connecteur 42 est relié aux conducteurs s'étendant dans les canaux 56a et 56b.

Des reliefs 57, par exemple en forme de plots tronconiques présents dans des coins diamétralement opposés du substrat 50, peuvent faire saillie sur les faces principales du substrat 50 pour s'engager dans des trous correspondants des capots 32 et assurer leur positionnement sur le substrat 50.

On voit sur la figure 7 que le fond de chaque logement 51 est surélevé par rapport au fond des logements 52 et 53, pour tenir compte de l'épaisseur des éléments de connexion reçus dans ces logements et faciliter le raccordement électrique aux contacts de puissance correspondants des transistors 60a, 60b.

Les transistors 60a, 60b sont de préférence prévus pour dissiper la chaleur par leur face extérieure, opposée au substrat 50.

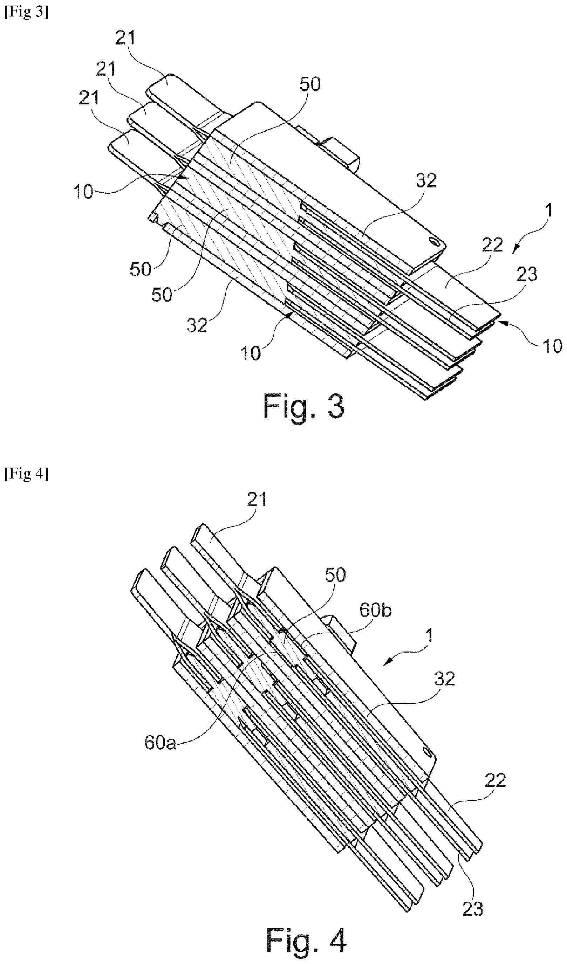

La face extérieure des transistors 60a, 60b est avantageusement en contact thermique avec la face intérieure du capot 32 adjacent, comme on peut le voir notamment sur la figure 4.

La capacité 70 présente des contacts qui se superposent aux éléments de connexion 22 et 23, et qui assurent une liaison électrique avec ces derniers.

L'ouverture 58 est relativement proche des transistors 60a, 60b, comme on peut le voir sur la figure 9, minimisant ainsi les inductances parasites. L'ouverture 58 est de préférence plus proche des transistors 60a, 60b que du contour extérieur du substrat 50 en vue de dessus, c'est-à-dire lorsque le substrat 50 est observé perpendiculairement à son plan.

Les éléments de connexion 22 et 23 peuvent présenter une largeur qui décroit en direction du transistor 60a ou 60b adjacent, comme illustré.

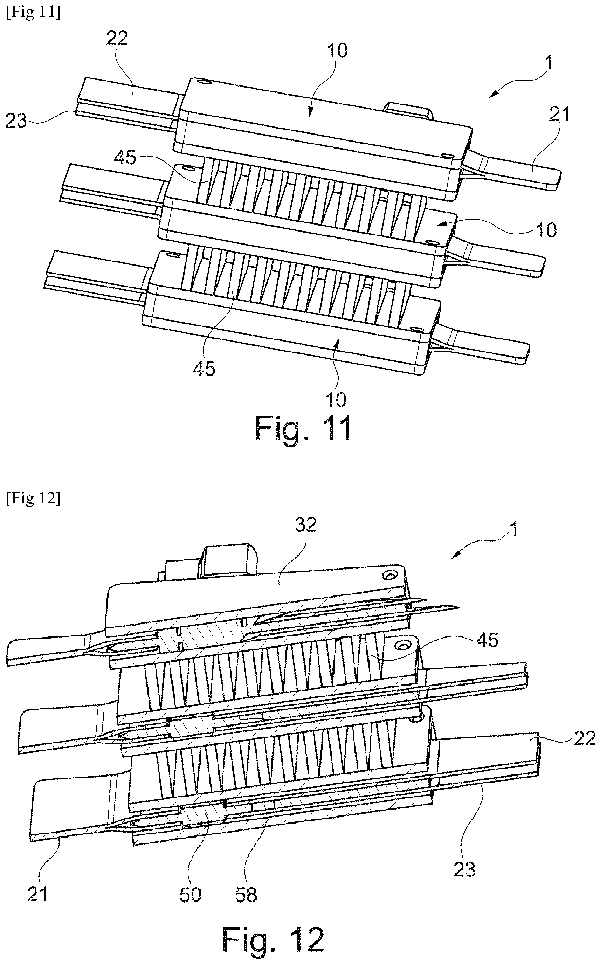

On peut réaliser l'ensemble 1 avec des moyens de dissipation thermique supplémentaires, comme illustré sur les figures 10 à 12.

Sur ces figures, on a représenté une variante d'ensemble 1 dans laquelle deux capots adjacents 32 de modules successifs 10 sont reliés par des ailettes de refroidissement 45. Les capots 32 ainsi reliés forment un double capot.

Les ailettes 45 sont par exemple réalisées d'un seul tenant avec les capots auxquels elles se raccordent.

Des moyens de convection forcée peuvent être prévus pour refroidir l'ensemble 1, en soufflant un flux d'air entre les ailettes 45, ou en variante en y faisant circuler un liquide de refroidissement.

Bien entendu, l'invention n'est pas limitée aux exemples qui viennent d'être décrits.

On peut par exemple apporter de nombreuses modifications au substrat et aux éléments de connexion notamment.

Par exemple, le premier élément de connexion 21 peut être réalisé avec une forme différente, par exemple telle que celle illustrée à la figure 13.

Sur cette figure, on voit que l'élément de connexion 21 peut comporter des première et deuxième branches 24 décalées latéralement, s'étendant depuis une partie de jonction 90 reliant les branches 24 entre elles, chaque branche étant reliée à la partie de jonction 90 par un premier coude 91 sensiblement à angle droit, les deux premiers coudes 91 étant dirigés dans des directions opposées, et chaque branche 24 comportant un deuxième coude 92 sensiblement à angle droit, de telle sorte que les portions terminales des première et deuxième branches soient sensiblement parallèles, ces portions terminales étant reliées électriquement chacune à un contact électrique de puissance d'un transistor 60a ou 60b respectif.

Dans des variantes non illustrées, chaque module ou une partie de ceux-ci peut recevoir une circulation d'un liquide de refroidissement.

## Revendications

1. Ensemble (1) de modules de puissance (10), comportant au moins deux modules de puissance (10) superposés, mieux au moins trois modules superposés, chaque module de puissance (10) comportant :
- Un substrat isolant électrique (50), de préférence monolithique, définissant des faces principales opposées, le substrat (50) étant de préférence en une céramique, notamment une céramique à base de nitrure d'aluminium AlN ou d'alumine Al₂O₃,
- au moins un premier (60a) et un deuxième (60b) composant à semi-conducteur disposés l'un au-dessus de l'autre de part et d'autre du substrat (50) et reposant sur ses faces principales, chaque composant présentant au moins deux contacts de puissance, les deux composants (60a, 60b) étant de préférence des transistors à base de semi-conducteur à grand gap tel que le nitrure de gallium (GaN),
- un premier élément de connexion (21) relié électriquement à un premier contact de puissance du premier composant (60a) et à un premier contact de puissance du deuxième composant (60b),
- un deuxième élément de connexion (22) relié électriquement à un deuxième contact de puissance du premier composant (60a),
- un troisième élément de connexion (23) relié électriquement à un deuxième contact de puissance du deuxième composant (60b),
les premiers éléments de connexion (21) des modules étant disposés d'un même côté de l'ensemble,
les deuxièmes éléments de connexion (22) des modules étant disposés d'un même côté de l'ensemble,
les troisièmes éléments de connexion (23) des modules étant disposés d'un même côté de l'ensemble.

2. Ensemble selon la revendication 1, le premier élément de connexion (21) reliant électriquement entre eux le premier contact de puissance (60a) du premier composant et le premier contact de puissance du deuxième composant (60b), à l'extérieur du substrat (50).

3. Ensemble selon l'une des revendications précédentes, chaque composant (60a ; 60b) comportant au moins un contact de commande (G), chaque module (10) comportant au moins deux bornes de sortie, notamment des bornes de sortie définies par des connecteurs (41 ; 42) portés par le module, pour relier électriquement les contacts de commande des composants de puissance (60a, 60b) à un circuit de commande (80), toutes les bornes de sortie, notamment tous les connecteurs, étant situés d'un même côté du module, tous les connecteurs (41, 42) étant de préférence situés d'un même côté de l'ensemble (1) de modules.

4. Ensemble selon l'une quelconque des revendications précédentes, chaque substrat (50) présentant une ouverture (58) et chaque module comportant une capacité de découplage (70) s'étendant au moins partiellement à travers cette ouverture, étant reliée électriquement à un contact de puissance de l'un des composants (60a) et à un contact de puissance (60b) de l'autre composant, notamment étant située en regard des deuxième (22) et troisième (23) éléments de connexion et à leur contact, de préférence à proximité des composants (60a, 60b).

5. Ensemble selon l'une quelconque des revendications précédentes, le substrat (50) étant réalisé avec des faces principales non entièrement planes, présentant au moins un relief (51 ; 52 ; 53 ; 57) en creux ou en saillie de positionnement du composant présent sur la face correspondante, d'un capot et/ou de l'un desdits éléments de connexion.

6. Ensemble selon l'une quelconque des revendications précédentes, le substrat (50) ayant, au moins pour les reliefs (51) assurant le positionnement des composants (60a, 60b), une forme symétrique par rapport à un plan médian de symétrie le coupant à mi-épaisseur.

7. Ensemble selon l'une quelconque des revendications précédentes, le premier élément de connexion (21) étant formé par découpe et pliage d'une feuille d'un métal, de préférence du cuivre, le premier élément de connexion (21) comportant de préférence des première et deuxième branches (24) décalées latéralement, s'étendant depuis une partie de jonction (90) reliant les branches entre elles, chaque branche étant reliée à la partie de jonction par un premier coude (91) sensiblement à angle droit, les deux premiers coudes étant dirigés dans des directions opposées, et chaque branche comportant un deuxième coude (92) sensiblement à angle droit, de telle sorte que les portions terminales des première et deuxième branches soient sensiblement parallèles, ces portions terminales étant reliées électriquement chacune à un contact électrique d'un composant respectif (60a ; 60b).

8. Ensemble selon l'une quelconque des revendications 1 à 7, le premier élément de connexion (21) comportant deux branches (24) superposées s'étendant au contact l'une de l'autre sur une partie de leur longueur puis à distance l'une de l'autre sur le reste de leur longueur.

9. Ensemble selon l'une quelconque des revendications précédentes, les éléments de connexion (21 ; 22 ; 23) présentant des parties qui s'étendent hors du substrat et qui définissent des bornes électriques.

10. Ensemble selon l'une quelconque des revendications précédentes, chaque module (10) comportant des capots opposés (32), en contact thermique avec des faces respectives des composants (60a ; 60b) opposées au substrat.

11. Ensemble selon l'une quelconque des revendications précédentes, les deux composants de chaque module étant des transistors reliés ensemble pour former un demi-pont, ou en variante un transistor et une diode, l'ensemble comportant de préférence au moins un refroidisseur entre deux modules adjacents, notamment un refroidisseur à ailettes (45).

12. Module de puissance (10), notamment pour la constitution d'un ensemble selon l'une quelconque des revendications précédentes, comportant :
- Un substrat monolithique isolant électrique (50), ayant des faces principales opposées,
- au moins un premier (60a) et un deuxième composant (60b) à semi-conducteur, disposés l'un au-dessus de l'autre de part et d'autre du substrat et reposant sur ses faces principales, chaque composant (60a ; 60b) présentant au moins deux contacts de puissance,
- un premier élément de connexion (21) reliant électriquement entre eux un premier contact de puissance du premier composant (60a) et un premier contact de puissance du deuxième composant (60b), à l'extérieur du substrat (50),
- de préférence un deuxième élément de connexion (22) relié électriquement à un deuxième contact de puissance du premier composant (60a),
- de préférence un troisième élément de connexion (23) relié électriquement à un deuxième contact de puissance du deuxième composant (60b).

13. Module de puissance (10), notamment pour la constitution d'un ensemble selon l'une quelconque des revendications 1 à 12, comportant :
- Un substrat isolant électrique (50), ayant des faces principales opposées,
- au moins un premier et un deuxième composant à semi-conducteur (60a, 60b) disposés l'un au-dessus de l'autre de part et d'autre du substrat et reposant sur ses faces principales, chaque composant présentant au moins deux contacts de puissance,
- un premier élément de connexion (21) reliant électriquement entre eux un premier contact de puissance du premier composant (60a) et un premier contact de puissance du deuxième composant (60b),
- au moins deux connecteurs (41, 42) de commande des composants de puissance (60a, 60b) du module, situés sur un même côté du substrat, avec de préférence une direction d'enfichage sensiblement parallèle à un plan médian du substrat coupant celui-ci à mi-épaisseur,
- de préférence un deuxième élément de connexion (22) relié électriquement à un deuxième contact de puissance du premier composant (60a),
- de préférence un troisième élément de connexion (23) relié électriquement à un deuxième contact de puissance du deuxième composant (60b).

14. Substrat (50), notamment pour la réalisation d'un module d'un ensemble selon l'une quelconque des revendications 1 à 12, ou d'un module de puissance selon l'une des revendications 13 et 14, présentant deux faces principales opposées définissant chacune un logement (51) pour recevoir un composant de puissance respectif (60a ; 60b) tel qu'un transistor de puissance, un logement (52) pour un élément de connexion (21) relié à un contact de puissance du composant de puissance (60a), un logement (52) pour un autre élément de connexion (22 ; 23) relié à un autre contact de puissance du composant, et au moins un canal (56b ; 55b) relié à un contact de commande du composant de puissance, les canaux (55b, 56b) pour les conducteurs de commande débouchant sur un même côté du substrat (50), pour les deux faces du substrat, le substrat étant de préférence réalisé en céramique.

15. Double capot, notamment pour la réalisation d'un module d'un ensemble selon l'une quelconque des revendications 1 à 12, comportant un premier capot (32) destiné à venir s'appliquer sur un premier substrat d'un premier module de puissance (10) et un deuxième capot (32) destiné à s'appliquer sur un deuxième substrat d'un deuxième module de puissance (10), les premier et deuxième capots étant solidaires, notamment en étant fixés face contre face ou en étant reliés par des ailettes (45), chaque capot présentant de préférence des reliefs de positionnement destinés à coopérer avec des reliefs correspondants (57) du substrat (50) contre lequel il est destiné à s'appliquer, pour se positionner d'une manière prédéfinie sur celui-ci, les capots (32) présentant de préférence des faces métalliques ou métallisées destinées à venir au contact des composants de puissance (60a, 60b) des modules (10).
